# EUROPÄISCHE PATENTSCHRIFT

(11) **EP 4 213 670 B1**
(45) Veröffentlichungstag und Bekanntmachung des Hinweises auf die Patenterteilung: **09.10.2024**
(21) Anmeldenummer: 20774983.9
(22) Anmeldetag: 21.09.2020
(51) Int. Cl.: A24F 40/40, A24F 40/42, A24F 40/51, A24F 40/60, A24F 40/90, A24F 40/10

(54) **MODULARE ELEKTRISCHE ZIGARETTE**
MODULAR ELECTRONIC CIGARETTE
CIGARETTE ÉLECTRONIQUE MODULAIRE

(43) Veröffentlichungstag der Anmeldung: 26.07.2023
(73) Patentinhaber: CARNAULT AG, 4057 Basel (CH)
(72) Erfinder: KAISER, Benjamin, 4057 Basel (CH); KAISER, Tobias, 4056 Basel (CH); BAUER, Stefan, 83064 Raubling (DE); BOCK, Daniel, 09111 Chemnitz (DE); SCHWITZER, Michael, 09244 Lichtenau (DE)
(74) Vertreter: Schirbach, Marcel
(86) Internationale Anmeldenummer: PCT/EP2020/076325
(87) Internationale Veröffentlichungsnummer: WO 2021/254650

(56) Entgegenhaltungen:
- EP-A1- 3 240 442
- EP-A2- 3 043 663
- EP-A2- 3 369 328
- DE-U1- 202014 004 361
- US-A1- 2017 000 190

## Beschreibung

### Gebiet der Erfindung

Die vorliegende Erfindung fällt in das Gebiet des täglichen Lebensbedarfs und betrifft eine modulare elektrische Zigarette gemäss dem Oberbegriff des Anspruchs 1.

### Stand der Technik, technologischer Hintergrund der Erfindung

Herkömmliche elektrische Zigaretten sind handliche Geräte, welche unter Einsatz von elektrischer Energie aus einer Vorläuferzusammensetzung ein inhalierbares Aerosol erzeugen. Zu diesem Zweck verfügt jede elektrische Zigarette mindestens über die nachfolgenden Funktionselemente: eine Energiequelle, elektronische Steuerkomponenten, eine Vorläuferzusammensetzung und eine Aerosolisierungseinheit. Letztere kann aus einem Heizelement, z.B. einem Glühdraht oder einem Heizchip, oder einer anderweitigen Baugruppe bestehen, welche in der Lage ist, die Vorläuferzusammensetzung in ein Aerosol zu überführen, z.B. mithilfe eines Ultraschall-Zerstäubers, oder mittels einer Ein- oder Zweistoffzerstäuberdüse. Die Vorläuferzusammensetzung kann dabei einerseits aus einem Liquid bestehen oder andererseits Festbestandteile beinhalten, wie z. B. präparierte Tabakerzeugnisse (sogenannte Heat-not-Burn-Produkte).

Elektrische Zigaretten sind darauf ausgelegt, gleich traditionellen Tabakzigaretten verwendet zu werden. Ein Nutzungsszenario, wie es beim Konsum einer traditionellen Tabakzigarette die Regel ist und folglich bei elektrischen Zigaretten im Bereich des Erwartbaren liegt, bestünde darin, dass mehrmals hintereinander mit kurzen Pausen zwischen den einzelnen Zügen das durch die elektrische Zigarette erzeugte Aerosol inhaliert wird. Ein solcher Vorgang, wobei die elektrische Zigarette üblicherweise in der Hand gehalten, an den Mund geführt und schließlich das Aerosol in Form einer Art Nebel oder Dampf ein- und in Teilen wieder ausgeatmet wird, ist auch durch eine erwünschte Sicht- und Wahrnehmbarkeit gegenüber Außenstehenden beeinflusst. Das Rauchen traditioneller Tabakzigaretten wurde und wird in vielen Teilen der Welt massiv beworben. Dabei wurde und wird mitunter versucht, es mit positiven Werten, wie Geselligkeit, Authentizität und Freiheit in Verbindung zu bringen. Der globale Erfolg traditioneller Tabakzigaretten, welcher sich in der hohen Zahl an Konsumenten von mehr als einer Milliarde Menschen ausdrückt, könnte ein Zeichen dafür sein, dass dieser Versuch mindestens teilweise geglückt ist. So legt auch die Tatsache, dass das Rauchen von Tabakzigaretten extrem weit verbreitet ist, nicht jedoch die Verwendung von ähnlich wirkenden, oft günstigeren und in einigen Fällen weitaus weniger schädlichen nikotinhaltigen Produkten, wie z.B. Oraltabak, nahe, dass gerade die hohe Sicht- und Wahrnehmbarkeit des Rauchvorgangs und des Produkts einen maßgeblichen Einfluss auf dessen Erfolg hat beziehungsweise dessen Fähigkeit, mit positiven Werten verknüpft zu werden.

Diese Erwägungen lassen den Schluss zu, dass der Erfolg einer elektrischen Zigarette ebenfalls in hohem Maße von der Außenwahrnehmung des Produkts selbst und von der Außenwahrnehmung während der Verwendung des Produkts abhängig ist. Im gleichen Sinne liegt auch der Schluss nahe, dass das Design für die Frage mitentscheidend ist, inwiefern sich eine elektrische Zigarette mit eben jenen Werten glaubhaft verbinden lässt, welche der Tabakzigarette zu besagtem Erfolg verholfen haben. Dabei sei festzuhalten, dass diese bereits oben beschriebenen Werte mindestens insofern als zeitlos zu bezeichnen sind, da es sich für Menschen um fundamentale, in beinahe jeder Kultur ausgiebig und intensiv thematisierte Werte handelt, bei denen davon ausgegangen werden kann, dass sie auch in der Zukunft relevant sein werden. Das Produktdesign ist damit ein wesentliches Differenzierungsmerkmal sowohl gegenüber anderen elektrischen Zigaretten als auch gegenüber traditionellen Tabakzigaretten und kann unter Umständen das einzige Unterscheidungskriterium sein, welches nach außen hin sichtbar ist. Es kann folglich von erfolgsentscheidendem Vorteil sein, wenn sich eine elektrische Zigarette durch einen oder mehrere der folgenden Aspekte auszeichnet, namentlich eine hochwertige Materialwahl der nach außen hin sichtbaren Baugruppen, eine hohe Verarbeitungsqualität, eine hohe Lebensdauer, Möglichkeiten der Individualisierung des Außen-Designs, etwa durch eine Austauschbarkeit von Baugruppen, eine geringe Produktgröße, die einer angenehmen Handlichkeit bzw. Haptik und einer einfachen Handhabung entgegenkommt, und Dimensionen, welche der Form und Größe einer klassischen Tabakzigarette so nahe wie möglich kommen, da man davon ausgehen kann, dass viele Menschen an die Form und Größe klassischer Tabakzigaretten gewöhnt sind und zudem an deren Gewicht. Ferner sind heute Aspekte wie Umweltfreundlichkeit, Abfallminimierung, Recyclingfähigkeit und die Abfalltrennung von Materialien von Bedeutung. Selbiges gilt hinsichtlich der Materialwahl. Ausgewählte Materialien, wie z. B. Holz oder Ebonit sind Rauchern aus zigarettenverwandten Produkten wie Tabakpfeifen wohl bekannt, wodurch der Rückgriff auf solche Materialien bei elektrischen Zigaretten gleichfalls eine Vertrautheit bei Rauchern hervorzurufen vermögen könnte.

Ferner soll in der elektrischen Zigarette eine Steuerelektronik ein zuverlässiges und sicheres Funktionieren der Aerosolerzeugung gewährleisten und gegebenenfalls erweiterte Funktionen umfassen, wie beispielsweise die Möglichkeit einer Bluetooth-Anbindung an ein Smartphone oder einer Authentifizierung des Verbrauchsguts in einer sogenannten Cartridge bzw. Patrone und ferner eine Mengenkontrolle; dabei geht der erweiterte Funktionsumfang unmittelbar mit einem erhöhten Platzbedarf für elektronische Komponenten bzw. für elektronische Bauelemente einher, z.B. für komplexere Schaltungsstrukturen in und um integrierten Schaltkreisen [IC - integrated circuits]. Zudem umfasst eine solche Steuerelektronik ein Einschaltelement in Form eines Schalters, Tasters oder Sensors, welcher einen Luftzug des Kunden zu registrieren vermag (z. B. Drucksensor, Luftflusssensor, Temperatursensor), sowie gegebenenfalls Anzeigeelemente, wie z. B. eine LED, und Komponenten zur Auswertung. Des Weiteren ist die Modularität von elektrischen Zigaretten zwecks Austausches einzelner Komponenten im Fall von Weiterentwicklungen und Verbesserungen oder im Schadensfall von Vorteil. Hierzu sind diverse Schnittstellen und Kontakte erforderlich, welche einen zusätzlichen Platzbedarf erforderlich machen können.

Bei einer Akkuzelle ist als Energiequelle eine hohe abrufbare Stromstärke und eine möglichst hohe nutzbare Kapazität vorteilhaft, wobei damit die positive Korrelation zwischen Akkukapazität und maximalem Entladestrom einhergeht, sowie der meist unvorteilhaften positiven Korrelation zwischen Kapazität, maximalem Entladestrom und einem entsprechend grossen Volumen bzw. einer entsprechend grossen Masse einer solchen Akkuzelle.

Selbstverständlich bleiben mit Blick auf geringe Produktionskosten wirtschaftliche Aspekte nicht ausser Acht, die auf eine entsprechend einfache Montage, günstige Komponenten oder einen hohen Grad an Automatisierung abstellen.

Einige der oben genannten Anforderungen an elektrische Zigaretten stehen zueinander in einem Zielkonflikt und bedürfen somit ein Abwägen zwischen unbedingt zu erfüllenden Vorteilen und damit andererseits einhergehenden zweitrangigen Nachteilen.

So führt beispielsweise die Verwendung natürlicher Materialien wie z. B. Holz oder Ebonit dazu, dass eine gewisse der Stabilität geschuldete Mindestwandstärke nicht unterschritten werden kann, die grösser ausfällt als etwa bei Edelstahl oder anderweitigen Metallen und Legierungen, so dass z. B. Hülsen aus Holz oder Ebonit mit einem erhöhten Platzbedarf einhergehen. Um der Form und Grösse einer Tabakzigarette möglichst treu bleiben zu können und gleichsam eine technisch fortschrittliche elektrische Zigarette realisieren zu können, macht dies eine platzsparende Konstruktion unumgänglich.

Des Weiteren hat zum Beispiel eine kreiszylindrische Gehäuse-Form zur Folge, dass die Batteriezelle, um optimal in diese Form hineinpassen zu können, ebenfalls kreiszylindrisch sein muss. Allerdings gilt zumindest für kleine Zellgrössen, dass sich bei gleichem Volumen quaderförmige Akkuzellen mit einer höheren Kapazität realisieren lassen als kreiszylindrische Akkuzellen. Dies liegt im grundsätzlichen Lagenaufbau von Akkuzellen begründet. Bei einer runden Zelle werden die Elektroden- und Separator-Lagen zumeist aufgerollt, wodurch aufgrund des beschränkten Krümmungswinkels der verwendeten Lagen mittig ein ungenutzter Hohlraum entsteht. Umso wichtiger ist eine effiziente Bauraumnutzung in einem kreiszylindrischen Gehäuse. Ein quaderförmiger Gehäuseaufbau kommt zusätzlich auch der Bauweise von Leiterplatten entgegen. Eine flache und rechteckige Leiterplatten-Form lässt sich ohne Einbussen in Sachen Baugrösse oder Funktionalität leichter realisieren und kann zur gleichen Zeit platzeffizient in ein quaderförmiges Gehäuse integriert werden. Die elektronischen Komponenten, mit welchen die Leiterplatte einer Kontrolleinheit bestückt wird, sind oftmals selbst rechteckig, entsprechend lassen sie sich auf einer rechteckigen Leiterplatten-Fläche effizienter anordnen als auf einer runden. Ein quaderförmiges Gehäuse kommt somit der Bauform von Akkuzellen und Leiterplatten eher entgegen als es bei einem kreiszylindrischen der Fall wäre und würde beispielsweise den Zielkonflikt kleine Produktgrösse, möglichst leistungsfähige Akkuzelle und gute Platzausnutzung der Leiterplatte vereinfachen. In der Folge entfernt man sich aber von dem Ziel der Ähnlichkeit zur Tabakzigarette.

Unter den Aspekten der Nachhaltigkeit und Wirtschaftlichkeit macht ein Einsatz hochwertiger Materialien oder das Investieren in eine hohe Verarbeitungsqualität nur dann Sinn, wenn die entsprechenden Bauteile eine gewisse Haltbarkeit aufweisen. Folglich wäre es von Nachteil, wenn die Lebensdauer einer Batteriehülse, welche im zusammengebauten Zustand der elektrischen Zigarette den größten Teil der sichtbaren Fläche einnimmt und ein zentrales Design-Objekt darstellt, an die vergleichsweise begrenzte Lebensdauer der darin angeordneten Akkuzelle geknüpft wäre, wenn beide Teile fix miteinander verbunden wären. Um eine hohe Verarbeitungsqualität und einen Einsatz hochwertiger Materialien im Besonderen im Bereich der Batteriehülse auf sinnvolle Weise nachhaltig und wirtschaftlich anwendbar machen zu können, ist ein modular trennbarer Aufbau der Steuerelektronik bzw. Kontrolleinheit, der Batteriezelle und der Batteriehülse eine Voraussetzung. Ein hoher Grad an Modularität steht hier regelmässig im Widerspruch zu einer geringen Produktgröße, da die einzelnen Teile über trennbare mechanische und elektrische Verbindungen verfügen müssen, welche generell zusätzlichen Platz einnehmen. Außerdem, da höhere Anforderungen an die Konstruktion gestellt werden, kann diese komplexer werden: es kann sein, dass mehr und/oder komplexere Bauteile benötigt werden oder es eine größere Zahl an Arbeitsschritten für die Fertigung braucht, was negative Auswirkungen auf die Endmontage und die Produktionskosten hätte.

Möglichst leistungsstarke Akkuzellen stehen einer möglichst hohen Funktionalität der Steuerelektronik und einer geringen Produktgröße entgegen. Eine einfache Montage der elektrischen Zigarette kann im Widerspruch zu einer immer komplexer werdenden Steuerelektronik stehen, welche zuweilen den Einsatz flexibler Leiterplatten oder diverser Verkabelungen und zusätzlicher Teile zum Verbinden der Leiterplatte mit dem Gehäuse, zum Beispiel Spritzgussteile etc. zur Folge hat.

Eine einfache technische Bedienung kann ebenfalls negative Auswirkungen auf den Platzbedarf und die Produktgröße haben, dabei ist zudem erstrebenswert, dass die elektrische Zigarette während der Aufladung des Akkus in einem zusammengebauten und quasi funktionsfähigen Zustand verbleibt. Eine solche Ladbarkeit nimmt dabei möglicherweise zusätzlichen Raum ein im Gegensatz zu einem permanenten Verschluss, der keine weiteren Funktionen abbildet, etwa weil zusätzliche Verkabelungen erforderlich werden können. Ebenso können gesteigerte Anforderungen an die Funktionalität oder an die elektrische Konstruktion zu einem erhöhten Platzbedarf führen. Die Erkennung von Änderungen des Luftdruckes oder Luftdurchsatzes beim Rauchvorgang, so dass die elektrische Zigarette gleich einer Tabakzigarette benutzt werden kann, macht beispielsweise ein Luftflussmanagement erforderlich. Oftmals wird dabei auf zusätzliche Bauteile nebst einem Drucksensor zurückgegriffen.

Die US 2018/368473 A1 offenbart eine universelle Verdampfer-Baugruppe für eine modulare, elektrische bzw. elektronischen Zigarette mit verschiedenen Geschmacksrichtungen. Diese universelle Verdampferbaugruppe umfasst vorliegend eine erste Gehäusekammer mit einem allgemein rechteckigen Querschnitt, die so konfiguriert ist, dass sie einen oder mehrere Saugstäbe aufweist; ferner ist an dieser ersten Gehäusekammer eine zweite Gehäusekammer lösbar angeordnet, die ebenfalls einen allgemein rechtwinkeligen Querschnitt aufweist und ein elektronisches Batteriemodul umfasst. Die erste und die zweite Gehäusekammer sind durch einen Verriegelungsmechanismus miteinander verbunden und bilden eine modulare Verdampfergruppe einer elektrischen Zigarette. Eine weitere herkömmliche, modulare elektrische Zigarette mit einem allgemein rechteckigen Querschnitt geht aus der Druckschrift WO 2018/014817 A1 hervor.

In der EP 3516972 A1 ist eine elektrische Zigarette offenbart, die eine Patroneneinheit und eine daran lösbar angeordnete Batterieeinheit aufweist, wobei die Patroneneinheit einen Zerstäuber mit einem Flüssigkeitsreservoir und eine Heizeinheit umfasst. Abgesehen davon, dass dieser Druckschrift kein Hinweis auf die Steuerung des Zerstäubers bzw. der gesamten elektrischen Zigarette entnehmbar ist, zeigt letztere zudem eine gegenüber herkömmlichen Zigaretten abweichende Aussenkontur mit einem ovalen Querschnitt.

Die US 1061748 B2 offenbart eine modulare elektrische Zigarette, die geeignet ist, flüssiges Material zu verdampfen, wobei diese elektrische Zigarette zudem mit einer Ausatemfilterfunktion ausgestattet ist. Eine bevorzugte Ausführungsform sieht eine einzigartige Form des Rauchinstruments vor, die im Querschnitt elliptisch ist und sich zum proximalen und distalen Ende hin jeweils verjüngt. Die CN 209376713 U zeigt eine ähnliche Aussenstruktur einer elektrischen Zigarette mit einem ovalen Querschnitt, wobei diese elektrische Zigarette lediglich am proximalen Ende verjüngt ist.

Dem zitierten Stand der Technik ist gemeinsam, dass die daraus bekannten, modularen elektrischen Zigaretten -mal abgesehen von ihren meist stark vergrösserten Aussenabmessungen im Vergleich zu Verbrennungszigaretten- einen im allgemeinen rechteckigen oder ovalen bzw. elliptische Querschnitt aufweisen, womit diese elektrischen Zigaretten quasi proprietäre Formen bzw. ebensolche Herstellermerkmale aufweisen, die auch auf eine Alleinstellung am Markt abzustellen gedacht sein können, um einerseits optische wie haptische Wiedererkennungsmerkmale bei Verbrauchern zu verankern und andererseits zu verhindern, dass einzelne Module bekannter elektrischer Zigaretten allein wegen ihrer äusseren Form oder ihrer Abmasse mit Konkurrenzprodukten kompatibel sind. Dies kann aber auch erforderlich erscheinen lassen, dass Konsumenten konventioneller elektrischer Zigaretten ein deutliches Mass an recht individueller Identifikationsbereitschaft für diese proprietären Herstellermerkmale mitbringen, um sich einerseits mit weiteren, gleichgesinnten Konsumenten zusammengehörig fühlen zu können oder andererseits sich im umgekehrten Fall auch abgrenzen bzw. distanzieren zu können. Weitaus kleiner sind -zumindest auf Distanz- die äusseren Unterscheidungsmerkmale herkömmlicher Verbrennungszigaretten unterschiedlicher Hersteller, wenn man einmal von der Art, der Grösse, der Farbgebung und der Beschriftung zugehöriger Verpackungen absieht, womit sich vor diesem Hintergrund und auf den ersten Blick lediglich zwei Gruppen ausmachen lassen, namentlich diejenige Gruppe der Raucher und diejenige Gruppe der Nichtraucher. Hierdurch könnte es als deutlich einfacher wahrgenommen werden, sich mit einer Verbrennungszigarette der einen grossen Gruppe der Verbrennungszigarettenraucher zugehörig fühlen zu können als sich spontan mit den stark unterschiedlichen, elektrischen Zigaretten und deren auffälligen, proprietären äusseren Unterscheidungsmerkmalen in dieser Gruppe der Verbrennungszigarettenraucher wohlfühlen zu können.

Aus der Druckschrift DE202014004361U1 ist ein Akkumodul für eine Rauchvorrichtung (1) mit einem Gehäuse bekannt, mit einer in dem Gehäuse angeordneten ladbaren Stromquelle zum Betreiben der Rauchvorrichtung und einer Ladepolanordnung zum Laden der Stromquelle mit mindestens zwei Ladepolen, wobei das Akkumodul eine Verpolschutzschaltung aufweist, welche auf eine Eingangsgleichspannung an den Ladepolen eine Ausgangsgleichspannung einer vorgegebenen Polarität zum Laden der Stromquelle bereitstellt.

Aus der Druckschrift EP3369328A2 ist ein Ladesystem für elektronische Zigaretten bekannt, umfassend eine elektronische Zigarette mit einem ersten Satz elektrischer Kontakte, einem Zerstäuber und einer wiederaufladbaren Batterie zum Betreiben des Zerstäubers. Das System umfasst ferner eine Elektrodenbaugruppe, die mit einer Stromquelle verbunden werden kann und einen zweiten Satz elektrischer Kontakte aufweist, die so angeordnet sind, dass sie mit dem ersten Satz elektrischer Kontakte zusammenpassen, woraufhin die elektronische Zigarette über die Elektrodenbaugruppe Strom erhält, um die Batterie wieder aufzuladen, während sie für die Verwendung durch einen Raucher betriebsbereit bleibt. Elektrische Schaltkreise, die mit dem ersten Satz elektrischer Kontakte verbunden sind, umfassen einen ersten Schaltkreis zur Versorgung des Zerstäubers mit Batteriestrom und einen zweiten Schaltkreis zur Versorgung der Batterie mit Strom von einem Batterieladegerät zum Aufladen der Batterie, wobei der erste Schaltkreis mit dem zweiten Schaltkreis zusammenwirkt, um den Stromfluss über die Elektrodenanordnung zur Batterie zu unterbrechen, wenn der Zerstäuber aktiviert ist, und um den Stromfluss wieder aufzunehmen, wenn der Zerstäuber nicht mehr aktiviert ist.

Die Druckschrift US2017000190A1 offenbart eine elektronische Zigarettenvorrichtung, die ein äußeres Rohr, eine Heiz-Zerstäubungskomponente, die in dem äußeren Rohr untergebracht ist, eine PCB-Komponente, die an einem Boden der Heiz-Zerstäubungskomponente angeordnet ist, und eine Batterie umfasst, die elektrisch mit der PCB-Komponente verbunden ist. Die heizende Zerstäubungskomponente umfasst ein Heizelement, ein Verbindungsstück, das elektrisch mit der Unterseite des Heizelements verbunden ist, und ein Zerstäubungsrohr, das ummantelt außerhalb des Heizelements und des Verbindungsstücks angebracht ist. Das obere Ende des Zerstäubungsrohrs ist mit einem Flüssigkeitseinfülldeckel und einem abnehmbaren Inhalationsschnabel versehen und angeordnet. An der Unterseite des Verbinders befindet sich eine Leiterplatte. Ein Elektrodenkontakt, der zur elektrischen Verbindung mit der Leiterplatte verwendet wird, ist an der Oberseite der PCB-Komponente angeordnet. Eine Vielzahl von Mikro-Lufteinlasslöchern ist auf der gedruckten Leiterplatte installiert und angeordnet.

Die Druckschrift EP3043663A2 ist ein programmierbares System zur Raucherentwöhnung bekannt, umfassend ein elektronisches Verdampfungsgerätesystem, ein Gerät und einen Nikotinmanagementplan. Verfahren zur Reduzierung des Nikotinkonsums auf der Grundlage des Nikotinmanagementplans, um die Nikotinabhängigkeit zu verringern oder zu beseitigen. Die hier beschriebenen Systeme, Geräte und Methoden verwenden eine digitale Verarbeitungsvorrichtung in Kombination mit einem Mechanismus zur Freisetzung von Dampf, um Nikotin und nikotinfreie flüssige Substanzen aus Kartuschenkammern zu verdampfen und zu mischen, um Dämpfe zu erzeugen, die so konfiguriert sind, dass sie den Nikotinkonsum und die Abhängigkeit mit einer modulierten Rate über einen bestimmten Zeitraum auf der Grundlage des Nikotinmanagementplans reduzieren. Das System und die Vorrichtung können so konfiguriert werden, dass sie die während des Gebrauchs erfassten Daten verfolgen und melden und einem Benutzer und/oder einer klinischen Fachkraft eine Rückmeldung geben.

In der Druckschrift EP3240442A1 wird eine Vorrichtung (1) zum Erhitzen von rauchbarem Material beschrieben, um mindestens eine Komponente des rauchbaren Materials zu verflüchtigen. Die Vorrichtung (1) umfasst eine elektrische Stromquelle (24) mit einem positiven und einem negativen Anschluss (24a, 24b), einen Spannungsregler (26b) und ein Steuergerät (50) zum Steuern der Zufuhr von elektrischem Strom zu einem Heizelement (410) im Gebrauch. Einer der Plus- und Minuspole (24a, 24b) ist über den Spannungsregler (26b) elektrisch mit dem Steuergerät (50) verbunden. Der andere der positiven und negativen Anschlüsse (24a, 24b) ist über einen elektrisch leitenden Pfad, der den Spannungsregler (26b) umgeht, elektrisch mit dem Steuergerät (50) verbunden.

### Darstellung der Erfindung

Es ist deshalb Aufgabe der vorliegenden Erfindung, eine elektrische Zigarette dahingehend weiterzuentwickeln, dass unter Ausnutzung sämtlicher Vorteile bekannter, elektrischer Zigaretten (mit bzw. ohne Schadstoffe, heilende, medizinische Zusätze, Entwöhnungsmittel, reines Dampfen ohne Zusatzstoffe...), ein vereinfachter Aufbau mit einem hohen Mass an Modularität ermöglicht wird, und gegenüber herkömmlichen, elektrischen Zigaretten eine kleinere Bauform ermöglicht wird und eine erweiterte Funktionalität.

Die der Erfindung für die elektrische Zigarette zugrundeliegende Aufgabe wird gelöst durch die Merkmale des Anspruchs 1; die diesen Erfindungsgedanken weiterbildenden Merkmale sind jeweils Gegenstand der Unteransprüche 2 bis 12.

Mit Vorteil weist die elektrische Zigarette gemäss der vorliegenden Erfindung entlang einer zentralen Z-Achse von unten nach oben eine Patroneneinheit und eine daran lösbar angeordnete Kontrolleinheit auf, wobei die elektrische Zigarette unten mit einem Mundstückende und oben mit einer Ladespitze abschliesst, und wobei diese elektrische Zigarette über deren gesamte Längenausdehnung eine kreisrunde Querschnittsfläche aufweist und einen ersten und/oder einen zweiten und/oder einen dritten Steuerelementkörper mit einem jeweiligen Körperdurchmesser senkrecht zur zentralen Z-Achse umfasst und dabei dieser jeweilige Körperdurchmesser derart gewählt ist, dass der jeweilige Steuerelementkörper im Innern mit der elektrischen Zigarette einen Passsitz ausbildet, wobei der zweite Steuerelementkörper als eine Ladespitzensteuerung ausgebildet ist, die an der Ladespitze mit Passsitz angeordnet ist und die elektrische Zigarette nach oben abschliesst, dass der dritte Steuerelementkörper als eine Patronensteuerung ausgebildet ist, die die Patroneneinheit nach oben mit dem Passsitz abschliesst, und dass die Kontrolleinheit eine Batteriehülse mit einer nichtleitenden Aussenröhre und einer elektrisch leitenden Innenröhre umfasst, die eine elektrische Wirkverbindung zwischen der Ladespitzensteuerung, der Steuereinheit und der Patronensteuerung ausbildet.

Gegenüber dem Stand der Technik hebt sich die erfindungsgemässe elektrische Zigarette insbesondere mit ihrer kreisrunden Querschnittsfläche und durch ihren kompakten Aufbau vom Stand der Technik ab, wobei durch den oder die Steuerelementkörper mit zur elektrischen Zigarette ausgebildetem Passsitz eine wesentlich verbesserte Raumnutzung innerhalb dieser elektrischen Zigarette ermöglicht wird und zudem ein wesentlich höherer Modularitätsgrad, da jeder Steuerelementkörper bei Bedarf oder auf Wunsch zerstörungsfrei austauschbar ausgebildet ist. Bei einer besonders vorteilhaften Ausführungsform der Erfindung ist vorgesehen, dass die kreisrunde Querschnittsfläche der elektrischen Zigarette über deren Längenausdehnung durchwegs gleich gross ist, womit eine äussere Erscheinungsform bereitgestellt werden kann, die sich weitgehend an einer herkömmlichen Verbrennungszigarette anlehnen kann.

Eine weitere vorteilhafte Ausführungsform sieht vor, dass der erste Steuerelementkörper als eine Steuereinheit ausgebildet ist, die zwischen der Patroneneinheit und der Kontrolleinheit mit dem Passsitz angeordnet ist und die Kontrolleinheit zu dieser Patroneneinheit hin abschliesst. Diese Anordnung der Steuereinheit ist wegen ihres zentralen Sitzes zwischen der Kontrolleinheit und der Patroneneinheit vorteilhaft, da somit unmittelbar auf beide Einheiten, namentlich die Kontrolleinheit und die Patroneneinheit, steuernd bzw. regelnd eingegriffen werden kann.

Ferner ist eine Ausbildung der Ladespitzensteuerung, der Steuereinheit und/oder der Patronensteuerung als eine Leiterplattenstruktur von besonderem Vorteil, da somit eine besonders günstige Raumausnutzung innerhalb der elektrischen Zigarette für deren Steuerung und Regelung ermöglicht wird.

Bei einer weiteren vorteilhaften Ausführungsform der erfindungsgemässen, elektrischen Zigarette ist vorgesehen, mindestens einen Sensor und/oder der mindestens einen Mikrocontroller und/oder mindestens ein elektronisches Bauelement mit mindestens einer Leiterplatte als in die Leiterplattenstruktur eingebettete, integrierte elektronische Komponenten auszubilden, um somit eine ausserordentliche Funktionsdichte innerhalb einer jeden Leiterplattenstruktur bereitstellen zu können.

Mit Blick auf das erzielte, hohe Mass an Modularität ist es besonders vorteilhaft, wenn der zwischen der elektrischen Zigarette ausgebildete Passsitz des Steuerelementkörpers als eine Spielpassung ausgebildet ist, wobei der Steuerelementkörper gerade noch leicht verschiebbar angeordnet ist, oder wenn der mit der elektrischen Zigarette ausgebildete Passsitz des Steuerelementkörpers als eine Übergangspassung ausgebildet ist, wobei der Steuerelementkörper mit geringem Druck verschiebbar angeordnet ist. Jedenfalls ermöglicht die Anordnung mit Passsitz zumindest eine möglichst exakte Positionierung jedes Steuerelementkörpers in der elektrischen Zigarette und im Falle der Übergangspassung zudem ein angestrebtes Mass an Fixierbarkeit.

Weitere vorteilhafte Ausführungsformen werden anhand der nachfolgenden Figuren im Zusammenhang mit der detaillierten Erfindungsbeschreibung hervorgehoben.

Die elektrische Zigarette gemäss der vorliegenden Erfindung zeichnet sich mit ihrem herausragenden Modularitätsgrad zum einen mit Blick auf das breite, optionale Funktionsspektrum besonders aus und zum anderen deswegen, da durch den Modularitätsgrad nun auch bei der Materialwahl auf Materialien zurückgegriffen werden kann, welche in der Welt der Tabakprodukte wohlvertraut sind, namentlich z.B. Holz, Ebonit (Hartgummi aus Naturkautschuk und Schwefel) und Meerschaum (Sepiolith), welche allesamt aus der Kunst des Pfeifenbaus bekannt sind. Entsprechend erlaubt der Einsatz dieser Materialien eine glaubhaftere Verknüpfung mit jenen Werten, mit welchen Tabakprodukte seit jeher erfolgreich beworben werden, nämlich Freiheit, Selbstverwirklichung, Naturverbundenheit, Wertigkeit, Authentizität etc.

Als eine im Besonderen interessante Variante einer elektrischen Zigarette könnte sich zusätzlich eine nikotinfreie elektrische Zigarette erweisen. Dazu sei erneut vermerkt, dass die globale Prävalenz des Rauchens als dominierende Nikotindarreichungsform im Vergleich zu weniger schädlicheren Nikotindarreichungsformen wie zum Beispiel Snus, darauf hinweisen könnte, dass das Raucherlebnis einer Tabakzigarette nicht nur durch das darin enthaltene Nikotin, sondern auch durch die mit dem Rauchen assoziierten Werte, die Möglichkeiten der Selbstinszenierung des Rauchenden gegenüber Dritten und sich selbst, sowie das Schaffen eines Rituals geprägt sind und dass eben diese Aspekte neben dem enthaltenen Nikotin massgeblich zum Erfolg der Tabakzigarette beigetragen haben. Das psychische Abhängigkeitspotential von Tabakzigaretten könnte damit weitaus höher ausfallen, als dies bei anderen Formen der Nikotindarreichung der Fall ist.

Nach heutigem Wissenstand endet die körperliche Nikotinabhängigkeit bei Rauchenden etwa zwei Wochen nach Ende des Nikotinentzugs. Weit über diesen Zeitraum hinaus wirksam bleiben können jedoch die Bedeutung des Rauchrituals für Rauchende und oben genannte Aspekte des Raucherlebnisses die ausserhalb des Nikotins zu verorten sind. Es besteht demnach die Möglichkeit, dass Rauchende nach erfolgreichem Rauchstopp wieder zu Tabakzigaretten greifen, da sie zum Beispiel keinen adäquaten Ersatz für das Rauchritual oder die damit einhergehenden Möglichkeiten der Selbstinszenierung finden konnten. Ein anschliessender und erneuter Rückgriff auf Tabakzigaretten geht dabei unmittelbar mit einer erneuten Nikotinabhängigkeit einher.

Elektrische Zigaretten bieten hier grundsätzlich die Möglichkeit mit nikotinfreien Varianten ihrer Produkte zu arbeiten. Um Rauchenden jedoch einen wirksamen Ersatz all jener Aspekte des Raucherlebnisses bieten zu können, welche nicht mit Nikotin zusammenhängen, müssen sie mindestens glaubhaft mit den Werten assoziierbar sein, mit welchen Tabakzigaretten jahrelang beworben wurden und müssen dazu ein Design aufweisen, welches einerseits diese Assoziierungen zu leisten imstande sind und andererseits damit einhergehende Möglichkeiten der Selbstinszenierung und der Ritualisierung eröffnet. Ohne Zweifel kann es dabei zusätzlich förderlich sein Rauchende bzw. Ex-Rauchende zum Konsum solcher nikotinfreier elektrischer Zigaretten einzuladen, indem beim Inhalieren des Dampfes ein dem Kratzen von Zigarettenrauch nachempfundenes Feedback im Hals abgebildet wird, etwa durch den Einsatz von Gingerol in der zu verdampfenden Flüssigkeit, jenem Stoff also, welcher Ingwer seine Schärfe verleiht.

Zuletzt sei erwähnt, dass eine nikotinfreie Variante einer elektrischen Zigarette z.B. unter Einsatz von Gingerol der erste Schritt auf dem Weg hin zu einem nicht nur weniger schädlichen, sondern je nach zu verdampfender Flüssigkeit und zum Einsatz kommender Verdampfungstechnologie sogar gesundheitsförderndem Produkt sein kann. Eine solche nikotinfreie, womöglich gesundheitsfördernde elektrische Zigarette könnte dann auch für Nichtraucher interessant werden und eine Marktchance jenseits des Zielpublikums von Rauchenden und Ex-Rauchenden aufzeigen. Auch hier können die Wichtigkeit des Produktdesigns und die Möglichkeiten der Inszenierung nicht genügend hervorgehoben werden.

Dass die den elektrischen Zigaretten zugrunde liegende Technologie letztlich auch eine mögliche Verabreichungsform pharmakologischer Wirksubstanzen darstellt und auch für die Pharmaindustrie von Interesse sein könnte, sei an dieser Stelle lediglich erwähnt.

### Kurze Beschreibung der Figuren

Im Folgenden wird die Erfindung anhand von Figuren beispielhaft erläutert. Gleiche Gegenstände sind in den Figuren grundsätzlich mit gleichen Bezugszeichen versehen. An dieser Stelle wird darauf hingewiesen, dass die Figuren keinerlei einschränkende Wirkung auf den Erfindungsgegenstand haben, sondern lediglich mögliche Ausführungsformen des Erfindungsgedankens darstellen.

Es zeigen rein schematisch die
Fig. 1 eine perspektivische Darstellung der elektrischen Zigarette gemäss der Erfindung;
Fig. 2a, b, c eine Längsschnittdarstellung einer elektrischen Zigarette gemäss der Erfindung mit einer zentralen Z-Achse zwecks einer einfachen Beschreibung bei der Verortung einzelner Elemente der elektrischen Zigarette mittels der hier auch teilweise in den Figuren verwendeten Begriffe, «oben», «unten», «nach oben hin», «nach unten hin», «oberer Abschluss», «unterer Abschluss», «Oberseite», «Unterseite»; zudem ist eine vergrösserte Längsschnittdarstellung einer Patroneneinheit dieser elektrischen Zigarette gezeigt.
Fig. 3 eine Längsschnittdarstellung eines Steuerelementkörpers der elektrischen Zigarette, welcher Steuerelementkörper als eine Leiterplattenstruktur ausgebildet ist;
Fig. 4 eine weitere Längsschnittdarstellung des Steuerelementkörpers der elektrischen Zigarette, welcher Steuerelementkörper als Leiterplattenstruktur ausgebildet ist;
Fig. 5 eine Explosionsdarstellung der erfindungsgemässen elektrischen Zigarette;
Fig. 6 eine Querschnittdarstellung des Steuerelementkörpers der elektrischen Zigarette am Beispiel einer Steuereinheit, welche als Leiterplattenstruktur ausgebildet ist.

### Wege zur Ausführung der Erfindung

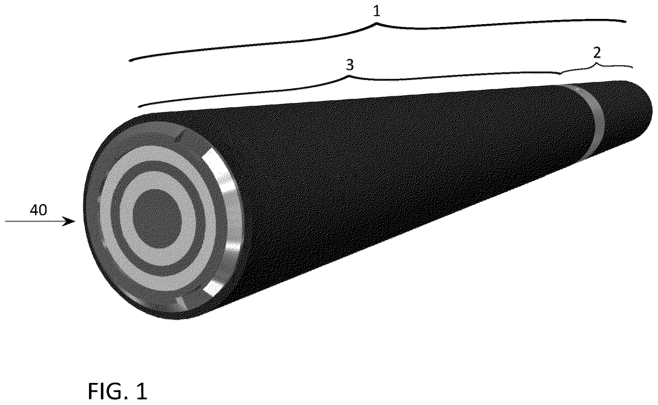

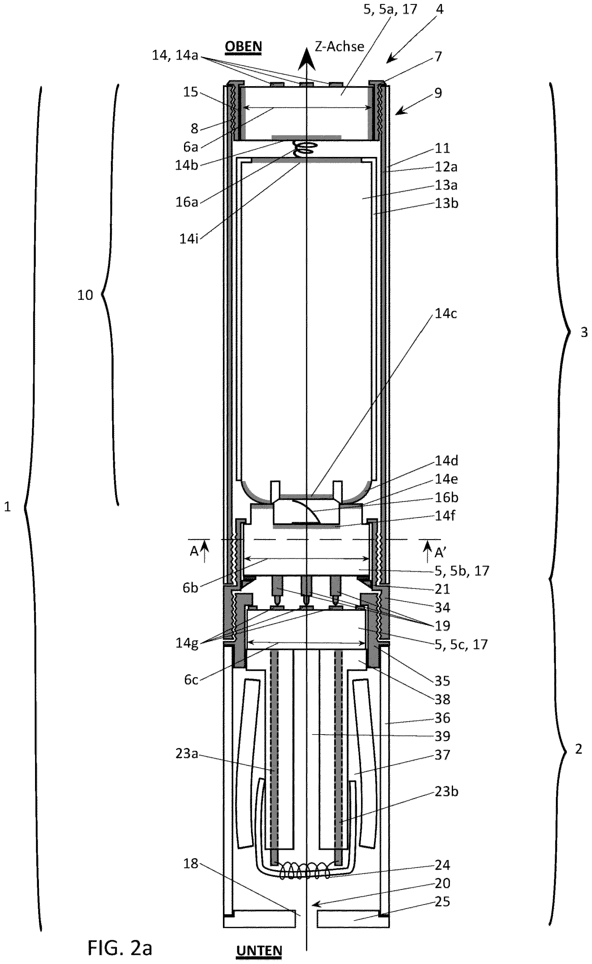

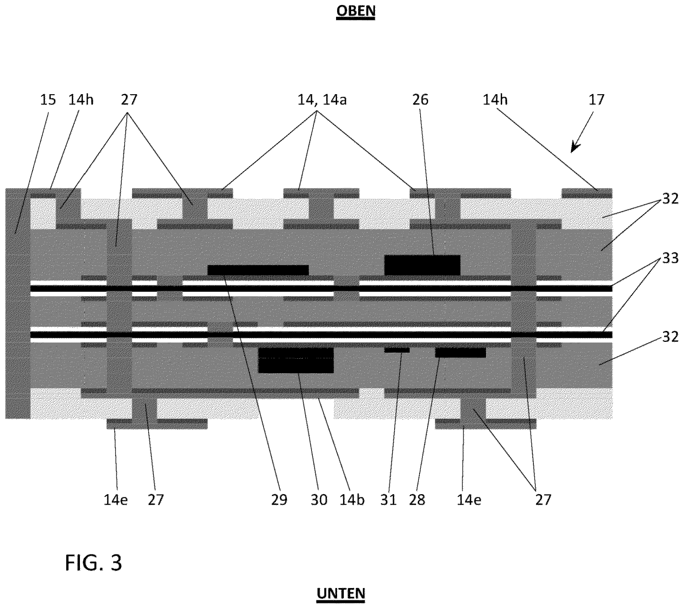

Fig. 1 zeigt eine perspektivische Darstellung der elektrischen Zigarette 1 gemäss der Erfindung, welche Zigarette 1 ein Patroneneinheit 2 und eine Kontrolleinheit 3 umfasst. Als ein erfindungswesentliches Merkmal weist diese elektrische Zigarette 1 eine kreisrunde Querschnittsfläche 40 auf und zwar über deren gesamte Längenausdehnung. Eine Längsschnittdarstellung dieser elektrischen Zigarette 1 zeigt sich in Fig. 2a; in dieser Fig. 2a ist die elektrische Zigarette 1 mit einer zentralen Z-Achse mit einer Pfeilspitze am oberen Ende zwecks einer einfachen Beschreibung bei der Verortung einzelner Bestandteile der elektrischen Zigarette 1 mittels der hier auch teilweise in den Figuren verwendeten Begriffe, «oben», «unten», «nach oben hin», «nach unten hin», «oberer Abschluss», «unterer Abschluss», «Oberseite», «Unterseite», usw. Vorliegend umfasst die erfindungsgemässe elektrische Zigarette 1 von unten nach oben eine Patroneneinheit 2 und eine daran lösbar angeordnete Kontrolleinheit 3, wobei an einem der Patroneneinheit 2 abgewandten Ende dieser elektrischen Zigarette 1 die Ladespitze 4 angeordnet ist. Diese Ladespitze 4 weist eine Anzahl elektrischer Kontaktflächen 14,14a auf, die zwecks einer Aufladung der elektrischen Zigarette 1 und/oder zwecks eines Datenaustauschs mit der elektrischen Zigarette 1 kontaktierbar sind. Die Ladespitze 4 umfasst einen Steuerelementkörper 5, der hier als eine Ladespitzensteuerung 5a mit einem Körperdurchmesser 6a senkrecht zur zentralen Z-Achse ausgebildet ist, wobei dieser Körperdurchmesser 6a derart gewählt ist, dass der Ladespitzensteuerung 5a mit der elektrischen Zigarette 1 einen Passsitz ausbildet. Mit dieser Art der Ausgestaltung wird insbesondere mit Blick auf den Körperdurchmesser 6a die grösstmögliche Raumausnutzung der Ladespitzensteuerung 5a ermöglicht, die zudem nach oben bzw. nach unten mit den elektrischen Kontaktflächen 14, 14a, 14b ausgestattet ist und zudem einen Mantelflächenkontakt 15 aufweist. Die Ladespitzensteuerung 5a ist vorliegend als eine Leiterplattenstruktur 17 ausgebildet, auf die nachfolgend und insbesondere unter Zuhilfenahme der Fig. 3 einzugehen sein wird. Die Ladespitze 4 ist einer Batterieeinheit 10 zugeordnet, die in einer Batteriehülse 9 eine Batterie 13a mit einer umgebenden Batterieisolierung 13b aufweist, welche Batterie 13a nach oben zur Ladespitzensteuerung 5a bzw. zu deren unterer elektrischer Kontaktfläche 14b eine elektrische Kontaktfläche 14i aufweist, wobei zwischen diesen beiden elektrischen Kontaktflächen 14b, 14i ein verbindender Federkontakt 16a angeordnet ist. In der vorliegenden Ausführungsform der Erfindung ist die Ladespitze 4 mit Passsitz in einem Verschlusselement 7 angeordnet, welches mittels einer Verbindungsstruktur 8 die elektrische Zigarette 1 nach oben hin verschliesst. Als Verbindungsstruktur 8 sind ein Gewinde ebenso denkbar wie ein Bajonettverschluss oder Rastelemente, wobei aber auch Klebetechniken unter der Vorgabe der Wiederlösbarkeit zum Einsatz gelangen können, da in jedem Fall ein modularer Aufbau der elektrischen Zigarette 1, bestehend aus gegebenenfalls austauschbaren Komponenten, angestrebt wird.

Die Ladespitzensteuerung 5a ist über den Mantelflächenkontakt 15 leitend mit dem Verschlusselement 7 verbunden und in der Folge über die Verbindungsstruktur 8 mit einer leitfähigen Innenröhre 12a der Batteriehülse 9. Diese leitfähige Innenröhre 12a ist nach aussen hin mit einer isolierenden Aussenröhre 11 umgeben. Am unteren Ende ist die leitfähige Innenröhre 12a mit einem Verschlussbauteil 34 und einem darin als Steuereinheit 5b ausgebildeten Steuerelementkörper 5 verschlossen, welche Steuereinheit 5b nach oben Kontaktflächen 14f bzw. 14e aufweist, die mit unteren Kontaktflächen 14c, 14d der Batterie 13a in Verbindung stehen, wobei ein Federkontakt 16b die Kontaktflächen 14c und 14f brückt. Der Steuerelementkörper 5 der Steuereinheit 5b weist einen Körperdurchmesser 6b auf, der mit der elektrischen Zigarette 1 ebenfalls einen Passsitz ausbildet, hier vorliegend mit dem Verschlussbauteil 34.

Die Steuereinheit 5b ist am unteren Ende mit einer Anzahl Kontaktstiften 19 ausgestattet, die mit Kontaktflächen 14g der Patroneneinheit 2 elektrisch wirkverbunden sind. Dabei ist mit Vorteil die Steuereinheit 5b ebenfalls wie die Ladespitzensteuerung 5a als eine Leiterplattenstruktur 17 ausgestaltet, auf die noch einzugehen sein werden wird. Von besonderem Vorteil ist, dass mittels der Kontaktflächen 14, 14a, 14b bzw. dem Mantelflächenkontakt 15 der Ladespitzensteuerung 5a an der Ladespitze 4 elektrische Wirkverbindungen über die leitfähige Innenröhre 12a der Batteriehülse 9 bis zur Steuereinheit 5b bzw. zu einem weiteren Steuerelementkörper 5 in der Patroneneinheit 2 bestehen, wobei dieser weitere Steuerelementkörper 5 hier als eine Patronensteuerung 5c ausgebildet ist. Mittels dieser elektrischen Wirkverbindungen kann über die Ladespitzensteuerung 5a, die Steuereinheit 5b bzw. die Patronensteuerung 5c neben der Aufladung der elektrischen Zigarette 1 auch ein durchgängiger Datenaustausch stattfinden, der zum Beispiel Schaltbefehle mitumfassen kann, oder aber Parametrierdaten oder Programmierdaten. Der Steuerelementkörper 5 der Patroneneinheit 5c weist hier einen Körperdurchmesser 6c auf, der mit der elektrischen Zigarette 1 auch einen Passsitz ausbildet, hier vorliegend mit einem Patronenabschluss 35.

In der hier vorliegenden Ausführungsform der Erfindung umfasst die Patroneneinheit 2 ein Reservoirgehäuse 36, welches nach oben mit dem Patronenabschluss 35 und darin angeordneter Patronensteuerung 5c versehen ist und mit einer Aerosolvorläuferzusammensetzung 37 befüllt ist; nach unten verschliesst ein Mundstückende 25 mit einer Mundstücköffnung 18 das Reservoirgehäuse 36. An der Patronensteuerung 5c sind nach unten eine erste und eine zweite Verbindungsleitung 23a, 23b angeordnet, die zur Mundstücköffnung 18 zwischen sich ein Heizelement 24 halten und mit Strom versorgen. Oberhalb des Heizelements 24 ist ein Luftkanal 39 angeordnet und unterhalb desselben eine Aerosolisierungszone 20.

Die mit Passsitz positionierten Steuerelementkörper 5, namentlich die Ladespitzensteuerung 5a, die Steuereinheit 5b und die Patronensteuerung 5c, sind wahlweise auf zwei unterschiedliche Arten in der elektrischen Zigarette 1 fixierbar. Eine Variante zeigt sich anhand der Ladespitzensteuerung 5a, die mit dem Verschlusselement 7 eine sogenannte Übergangspassung ausbildet und demzufolge derart fixiert ist, dass diese Ladespitzensteuerung 5a darin nur mit geringem Druck verschiebbar ist. Eine weitere Variante der Fixierung ist in Verbindung mit der Steuereinheit 5b gezeigt, die mittels Spielpassung im Verschlussbauteil 34 positioniert ist und von einem Pressring 21 darin fixiert wird. Eine ähnliche Positionierung bzw. Fixierung erfährt die Patronensteuerung 5c im Patronenabschluss 35, wo ein Luftkanalabschluss 38 pressringartig fixierend wirkt.

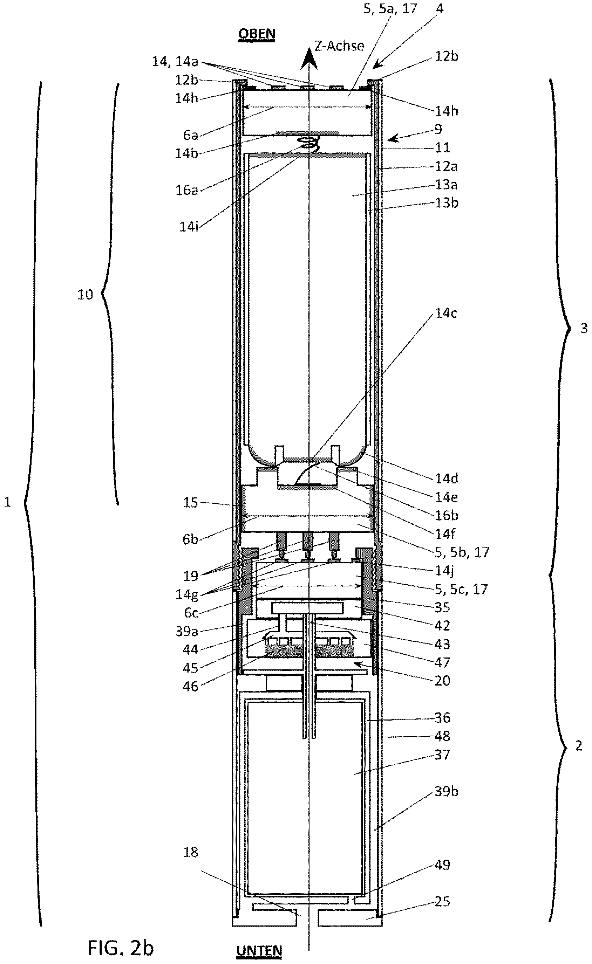

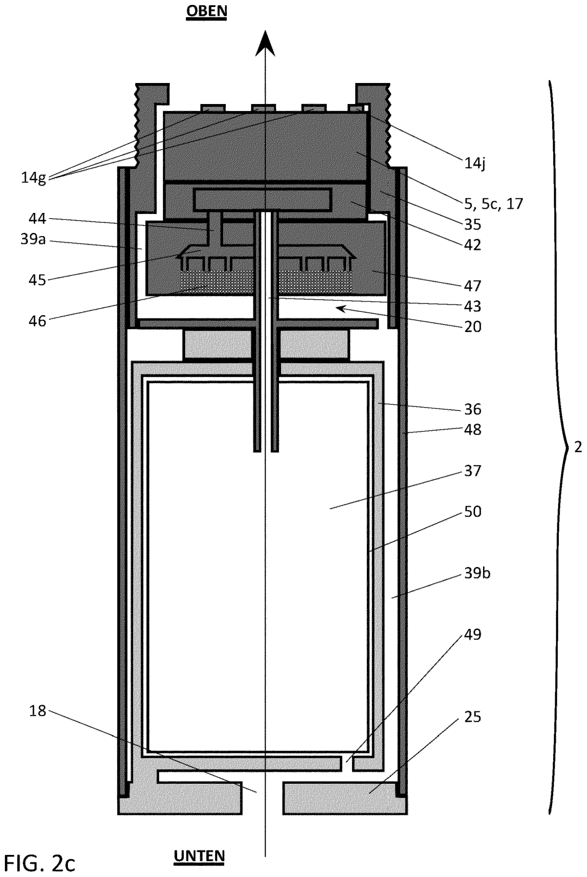

In Fig. 2b ist eine Ausführungsvariante für die Fixierung der Steuerelementkörper 5 in der elektrischen Zigarette gezeigt; vorliegend ist die Ladespitzensteuerung 5a mit einer Spielpassung in der Innenröhre 12a der Batteriehülse 9 positioniert, wobei sich diese Ladespitzensteuerung 5a mit elektrischen Kontaktflächen 14h gegen einen Flansch 12b der elektrisch leitfähigen Innenröhre 12a abstützt; ferner bildet in dieser Fig. 2b die Steuereinheit 5b mit einem Mantelflächenkontakt 15 eine Übergangspassung mit der Innenröhre 12a aus und die Patronensteuerung 5c bedient sich ebenfalls einer Übergangspassung zwecks Positionierung und Fixierung im Patronenabschluss 35. Des Weiteren zeigt die Fig. 2b eine Ausführungsform der Patroneneinheit 2, bei der an der Patronensteuerung 5c nach unten eine Mikropumpe 42 und in der Folge ein Heizchip 47 angeordnet sind. Die Mikropumpe 42 bedient sich über eine Nadel 43 aus einem Reservoirgehäuse 36 der Aerosolvorläuferzusammensetzung 37. Deutlich vergrössert offenbart die Fig. 2c diese Patroneneinheit 2, wobei erkennbar ist, dass diese Patroneneinheit 2 zwei Teilegruppen umfasst, wobei die eine Teilegruppe lösbar an der elektrischen Zigarette 1 angeordnet ist und dort auch verbleibt und die andere Teilegruppe als Verbrauchsgut nach Konsum auszutauschen gedacht ist. Die erste Teilegruppe, die an der elektrischen Zigarette 1 auch nach deren Nutzung verbleibt, umfasst den Patronenabschluss 35 mit der Patronensteuerung 5c, der Mikropumpe 42 und dem Heizchip 47 umgeben von der Patronenhülse 48 und die Nadel 43; die zweite Teilegruppe umfasst im Wesentlichen das in der Patronenhülse 48 eingesetzte Reservoirgehäuse 36 mit dem innen angeordneten Reservoir 50, der Aerosolvorläuferzusammensetzung 37 und dem Mundstückende 25. Nach der Nutzung der elektrischen Zigarette 1 wird lediglich die zweite Teilegruppe als eine Einheit ausgewechselt, wobei das Reservoir 50 beim Einsetzen in die Patronenhülse 48 mittels der Nadel 43 angestochen wird und die Aerosolvorläuferzusammensetzung 37 durch diese Nadel 43 von der Mikropumpe 42 angesaugt werden kann, um anschliessend über einen Zuführer 44 zu einem Verteiler 45 und abschliessend zu einem Verteilersubstrat 46 im Heizchip 47 weitergeleitet zu werden. Luft, die aus einem Luftkanal 39a zu einer Aerosolisierungszone 20 strömt, wird dort mit einem Aerosol aus der Aerosolvorläuferzusammensetzung 37 über den Luftkanal 39b einem Konsumenten an der Mundstücköffnung 18 bereitgestellt.

Das Reservoir 50 weist eine flexible Hülle auf, die sich bei Entnahme der Aerosolvorläuferzusammensetzung 37 entsprechend zusammenziehen kann, so dass bis zur Erschöpfung die Aerosolvorläuferzusammensetzung 37 an der Spitze der Nadel 43 bereitsteht; damit im Innern des Reservoirgehäuses 36 kein Vakuum ein weiteres Ansaugen der Aerosolvorläuferzusammensetzung 37 verhindert, weist das Reservoirgehäuse 36 eine Öffnung 49 auf, durch die Luft das entnommene Volumen der Aerosolvorläuferzusammensetzung 37 ersetzen kann. Die Mikropumpe 42 und der Heizchip 47 können beispielsweise aus Silizium bestehen und zudem einteilig ausgeführt sein. Aufgrund des hohen Modularitätsgrads ist es mit vorliegender elektrischer Zigarette 1 nach Nutzung nur noch notwendig, das befüllte Reservoirgehäuse 36 auszutauschen, womit auch dem Wunsch nach Nachhaltigkeit Rechnung getragen werden kann.

Wie bereits oben angesprochen, kann die Ladespitzensteuerung 5a, die Steuereinheit 5b und die Patronensteuerung 5c vorteilhafterweise als eine Leiterplattenstruktur 17 ausgebildet sein, wie sie in Fig. 3 gezeigt ist. Diese Leiterplattenstruktur 17 kann eine oder mehrere der nachfolgend gelisteten Funktionen der elektrischen Zigarette 1 aufweisen, namentlich eine Luftmengenmessung, eine Restmengenbestimmung für eine Aerosolvorläuferzusammensetzung 37, eine Ladezustandsbestimmung der Batterie 13a, eine Authentifizierungsvorrichtung oder eine Kommunikationseinrichtung (RFID, Bluetooth,...), gegebenenfalls für einen Datenaustausch mit einem Smartphone oder einer Smartwatch, wobei diese Funktionsliste als nicht abgeschlossen zu betrachten ist.

Fig. 3 zeigt nun eine beispielhafte Ausführungsform der Leiterplattenstruktur 17, mit den elektrischen Kontaktflächen 14h, 14, 14a, an der Oberseite bzw. 14b an der Unterseite derselben. Die hier vorliegende Leiterplattenstruktur 17 umfasst eine Anzahl von Leiterbahnen bzw. Durchkontaktierungen 27 und eine Anzahl integrierter Strukturen wie beispielsweise eine Authentifizierungseinheit 26, ein Schaltelement 28, einen Sensor 30, einen Mikrocontroller 29 und ein elektronisches Bauelement 31, welche auf mittels Isolationsfüllungen 32 voneinander isoliert ausgebildeten Leiterplatten 33 angeordnet sind. Mittels einer solchen Leiterplattenstruktur 17 sind eine Vielzahl von Funktionen der elektrischen Zigarette abbildbar, wobei gegebenenfalls weitere Strukturen ergänzt werden können oder weggelassen werden können. Ohne den Erfindungsgedanken zu verlassen ist es auch denkbar, dass weitere Funktionen in der Leiterplattenstruktur 17 integriert werden, die hier nicht explizit genannt sind.

Vorliegend offenbart Fig. 3 in einer stark vergrösserten Schnittdarstellung eine mögliche Ausführungsform für die Leiterplattenstruktur 17 der elektrischen Zigarette 1. In ihrer einfachsten Form umfasst diese Leiterplattenstruktur 17 mindestens eine Leiterplatte 33, die mit einem Sensor 30 und/oder einem oder mehreren elektrischen Bauelementen 31 und/oder einem Mikrocontroller 29 ausgestattet ist. Es ist hier ein beispielhafter Aufbau auf Basis eingebetteter elektronischer Bauelemente dargestellt. Die später innenliegenden Bauteile 29, 30, 31 werden in dieser hier dargestellten Einbett-Technologievariante mittels eines Lötverfahrens auf die jeweilige, z.B. durch Ätzen strukturierte Kupferlage aufgelötet und im weiteren Leiterplatten-Fertigungsprozess durch Decklagen aus einer Isolationsfüllung bzw. aus Leiterplattenmaterial 32 (Prepregs) abgedeckt. Die Kupferlagen, auf die die Bauteile gelötet werden, können entweder einzelne Folien oder wie im dargestellten Fall Bestandteil von vorbereiteten Zwei- oder MehrlagenLeiterplatten, bestehend aus mindestens einem Isolator, z.B. aus einem gehärteten Prepreg 32 und zwei aufgepressten Kupferlagen, sein. Abhängig von der Konstruktion und der Materialwahl wird z.B. das Harz in den Decklagen-Materialien während des nachfolgenden Leiterplatten-Pressprozesses zur Verfüllung von Freiräumen im Umfeld der eingebetteten Bauelemente genutzt.

Es sind weitere Einbett-Technologien verfügbar, die auch die Verarbeitung von nichtgehäusten aktiven elektronischen Komponenten, wie z.B. Mikrocontroller oder ASICs, ohne einen extra Lötprozess ermöglichen. Bei diesen Technologien werden für die Bauteilkontaktierung der später innenliegenden elektronischen Bauteile Standardverfahren aus der Leiterplattenindustrie, z.B. Mikrobohrungen (HDI-Technologie, Microvias) und Galvanik, genutzt. Der grundsätzliche Aufbau mit eingebetteten Bauelementen bleibt aber unabhängig von der gewählten Embedded-Variante weitgehend gleich. Auch mit den 3D-Druck-/Additivverfahren, z.B. auf Pasten-/Lackbasis mit Trocknung bzw. Aushärtung mit UV-Licht, lassen sich Mehrlagenleiterplatten mit eingebetteten Bauelementen herstellen.

Neben der Einbettung elektronischer Bauteile ermöglicht die Nutzung der Grossserien-tauglichen Leiterplattentechnologie auch eine komplexe 3D-Strukturierung der entstehenden Baugruppe mit Standardbearbeitungsverfahren bei gleichzeitig hoher Genauigkeit bzw. mit geringen Toleranzen. Dabei sind mechanische Führungen und zusätzliche äussere Kontaktelemente sehr leicht in abschliessenden Leiterplattenprozessen realisierbar.

Die verschiedenen Ebenen der Mehrlagenleiterplatte mit eingebetteten elektronischen Bauteilen werden mittels Durchkontaktierungen 27 (Microvias, Vias) in einem Leiterplatten-Standardprozess miteinander verbunden und sichern die elektrischen Verbindungen in der Z-Achse der kompakten Baugruppe.

Eine derart ausgebildete Leiterplattenstruktur 17 zeichnet sich gegenüber dem Stand der Technik neben der verbesserten Miniaturisierung auch durch kleineren Energieverbrauch und geringere Verlustleistung aus. Vorliegend umfasst die Leiterplattenstruktur 17 mehrere voneinander isoliert angeordnete Leiterplatten 33 mit eingebetteten Elementen, wie dem Mikrocontroller 29, dem Sensor 30 und dem elektrischen Bauelement 31, welche hier lediglich als Beispiele für weitere äquivalent ausgestattete Ausführungsformen stehen sollen; typischerweise sind die hier horizontal und somit senkrecht zur Z-Achse angeordneten Leiterplatten 33 von Isolationsfüllungen 2 beabstandet, wobei Leiterbahnen bzw. Durchkontaktierungen 27 teilweise oder vollständig die Leiterplattenstruktur 17 elektrisch verbinden.

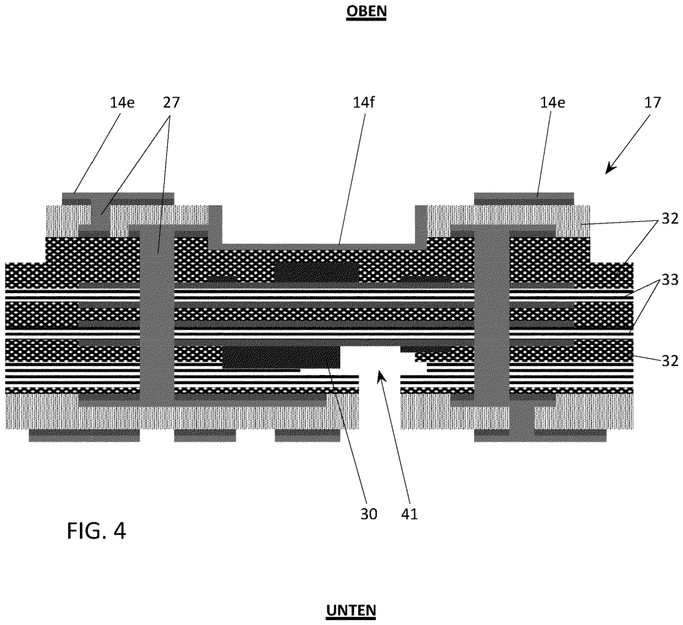

Fig. 4 zeigt eine Ausführungsform der Leiterplattenstruktur 17 gemäss Fig. 3 mit dem Unterschied, dass diese Leiterplattenstruktur 17 zusätzlich eine Kavität 41 mit einem innenliegenden Sensor 30 aufweist, der hier als Drucksensor 30 ausgebildet ist. Mit besonderem Vorteil ist die Steuereinheit 5b und/oder die Patronensteuerung 5c als eine solche Leiterplattenstruktur 17 ausgebildet, wobei der Drucksensor 30 unmittelbar mit dem Luftkanal 39, 39a bzw. 39b in Wirkverbindung steht, siehe auch Fig. 2a, 2b, 2c, um beim Ansaugen über die Mundstücköffnung 18 ein Einschalten der elektrischen Zigarette 1 zu bewirken. Somit kann der Drucksensor 30 in dieser Leiterplattenstruktur 17 als eingebettete, integrierte elektronische Komponente ausgebildet sein.

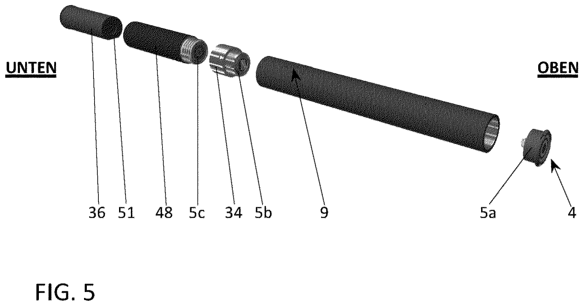

Fig. 5 zeigt in einer perspektivischen Explosionsdarstellung die elektrische Zigarette 1 gemäss der Erfindung, wie sie im Wesentlichen in Fig. 2b gezeigt und oben beschrieben ist. Das nach Gebrauch zu wechselnde Reservoirgehäuse 36 mit dem hiervon umschlossenen Reservoir 50 ist in die Patronenhülse 48 einführbar. Abweichend von der Darstellung in der Fig. 2b wird die Patronenhülse 48 mit der Patronensteuerung 5c in das Verschlussbauteil 34 eingesetzt, welches auch die Steuereinheit 5b umfasst. Das Verschlussbauteil 34 wird mit der Batteriehülse 9 verbunden, welche oben mit der Ladespitzensteuerung 5a verschlossen wird. Das Reservoirgehäuse 36 weist vorliegend eine Abflachung 51 auf, die in Verbindung mit der Patronenhülse 48 -siehe auch Fig. 2b, Fig. 2c- den Luftkanal 39b auszubilden vermag.

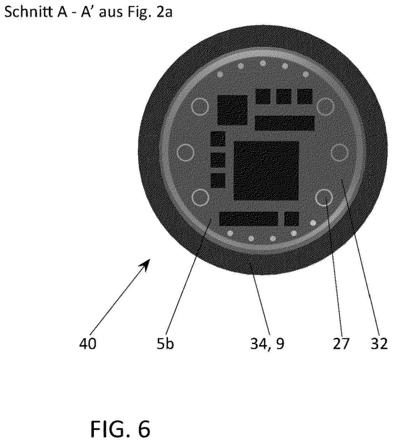

In Fig. 6 ist die erfindungswesentliche kreisrunde Querschnittsfläche 40 der elektrischen Zigarette 1 anhand eines Schnitts durch die Steuereinheit 5b gezeigt, die von dem Verschlussbauteil 34 und der Batteriehülse 9 in diesem Bereich umschlossen ist; vorteilhaft ist es, wenn diese kreisrunde Querschnittsfläche 40 über die gesamte Längenausdehnung der elektrischen Zigarette 1 gleich gross ist, so dass diese im äusseren Erscheinungsbild einer herkömmlichen Verbrennungszigarette möglichst nahe kommt.

### Bezugszeichenliste

- 1: elektrische Zigarette
- 2: Patroneneinheit
- 3: Kontrolleinheit
- 4: Ladespitze
- 5: Steuerelementkörper
- 5a: Ladespitzensteuerung
- 5b: Steuereinheit
- 5c: Patronensteuerung
- 6a, b, c: Körperdurchmesser
- 7: Verschlusselement
- 8: Verbindungsstruktur (Gewinde, Bajonette, Einrastung)
- 9: Batteriehülse
- 10: Batterieeinheit
- 11: Aussenröhre der 9, elektrisch nichtleitend
- 12a: Innenröhre der 9, elektrisch leitend
- 12b: Flansch an 12a
- 13a: Batterie
- 13b: Batterieisolierung
- 14, 14a, 14b, 14c: elektrische Kontaktfläche
- 14d, 14e, 14f, 14g 14h, 14i, 14j 15: Mantelflächenkontakt
- 16a, 16b: Federkontakt
- 17: Leiterplattenstruktur
- 18: Mundstücköffnung
- 19: Kontaktstift
- 20: Aerosolisierungszone
- 21: Pressring
- 23a, b: erste und zweite Verbindungsleitung
- 24: Heizelement
- 25: Mundstückende
- 26: Authentifizierungseinheit
- 27: Durchkontaktierung
- 28: Schaltelement
- 29: Mikrocontroller
- 30: Sensor
- 31: elektronisches Bauelement
- 32: Isolationsfüllung
- 33: Leiterplatte
- 34: Verschlussbauteil
- 35: Patronenabschluss
- 36: Reservoirgehäuse
- 37: Aerosolvorläuferzusammensetzung
- 38: Luftkanalabschluss
- 39, 39a, 39b: Luftkanal
- 40: Querschnittsfläche von 1
- 41: Kavität in 17
- 42: Mikropumpe
- 43: Nadel
- 44: Zuführer
- 45: Verteiler
- 46: Verteilersubstrat
- 47: Heizchip
- 48: Patronenhülse
- 49: Öffnung in 36
- 50: Reservoir
- 51: Abflachung an 36 für 39b

## Patentansprüche

1. Modulare elektrische Zigarette (1), welche entlang einer zentralen Z-Achse von unten nach oben eine Patroneneinheit (2) und eine daran lösbar angeordnete Kontrolleinheit (3) aufweist, wobei die elektrische Zigarette (1) unten mit einem Mundstückende (25) und oben mit einer Ladespitze (4) abschliesst, wobei die elektrische Zigarette (1) über deren gesamte Längenausdehnung eine kreisrunde Querschnittsfläche (40) aufweist und einen ersten und/ oder einen zweiten und/oder einen dritten Steuerelementkörper (5) mit einem Körperdurchmesser (6a, 6b, 6c) senkrecht zur zentralen Z-Achse umfasst, wobei dieser jeweilige Körperdurchmesser (6a, 6b, 6c) derart gewählt ist, dass der Steuerelementkörper (5) mit der elektrischen Zigarette (1) einen Passsitz ausbildet, **dadurch gekennzeichnet, dass** der zweite Steuerelementkörper (5) als eine Ladespitzensteuerung (5a) ausgebildet ist, die an der Ladespitze (4) mit Passsitz angeordnet ist und die elektrische Zigarette (1) nach oben abschliesst, dass der dritte Steuerelementkörper (5) als eine Patronensteuerung (5c) ausgebildet ist, die die Patroneneinheit (2) nach oben mit dem Passsitz abschliesst, und dass die Kontrolleinheit (3) eine Batteriehülse (9) mit einer nichtleitenden Aussenröhre (11) und einer elektrisch leitenden Innenröhre (12a) umfasst, die eine elektrische Wirkverbindung zwischen der Ladespitzensteuerung (5a), der Steuereinheit (5b) und der Patronensteuerung (5c) ausbilden kann.

2. Modulare elektrische Zigarette (1) gemäss Anspruch 1, **dadurch gekennzeichnet, dass** die kreisrunde Querschnittsfläche (40) der elektrischen Zigarette (1) über deren gesamte Längenausdehnung gleich gross ist.

3. Modulare elektrische Zigarette (1) gemäss einem der Ansprüche 1 oder 2, **dadurch gekennzeichnet, dass** der erste Steuerelementkörper (5) als eine Steuereinheit (5b) ausgebildet ist, die zwischen der Patroneneinheit (2) und der Kontrolleinheit (3) mit dem Passsitz angeordnet ist und die Kontrolleinheit (3) zu dieser Patroneneinheit (2) hin abschliesst.

4. Modulare elektrische Zigarette (1) gemäss einem der Ansprüche 1 bis 3, **dadurch gekennzeichnet, dass** die Ladespitzensteuerung (5a) und/oder die Steuereinheit (5b) und/oder die Patronensteuerung (5c) als eine Leiterplattenstruktur (17) ausgebildet ist.

5. Modulare elektrische Zigarette (1) gemäss Anspruch 4, **dadurch gekennzeichnet, dass** die Leiterplattenstruktur (17) mindestens eine mittels einer Isolationsfüllung (32) isolierte Leiterplatte (33) umfasst, wobei diese mindestens eine Leiterplatte (33) quer zur Z-Achse ausgerichtet ist.

6. Modulare elektrische Zigarette (1) gemäss Anspruch 5, **dadurch gekennzeichnet, dass** die mindestens eine Leiterplatte (33) mindestens einen Sensor (30) und/oder mindestens einen Mikrocontroller (29) und/oder mindestens ein elektronisches Bauelement (31) aufweist, welche elektrisch auf dieser mindestens einen Leiterplatte (33) und/oder mittels einer Leiterbahn und/oder mittels einer Durchkontaktierung (27) mit der Anzahl elektrischer Kontakte (14, 14a - 14i), oder mit einem Mantelflächenkontakt (15) in elektrischer Wirkverbindung stehen.

7. Modulare elektrische Zigarette (1) gemäss Anspruch 6, **dadurch gekennzeichnet, dass** der mindestens eine Sensor (30) und/oder der mindestens eine Mikrocontroller (29) und/oder das mindestens eine elektronische Bauelement (31) mit der mindestens einen Leiterplatte (33) als in die Leiterplattenstruktur (17) eingebettete, integrierte elektronische Komponenten ausgebildet sind.

8. Modulare elektrische Zigarette (1) gemäss einem der Ansprüche 4 bis 7, **dadurch gekennzeichnet, dass** die Leiterplattenstruktur (17) eine Authentifizierungsvorrichtung (26) umfasst.

9. Modulare elektrische Zigarette (1) gemäss einem der Ansprüche 4 bis 7, **dadurch gekennzeichnet, dass** die Leiterplattenstruktur (17) ein Schaltelement (28) umfasst.

10. Modulare elektrische Zigarette (1) gemäss einem der Ansprüche 6 oder 7, **dadurch gekennzeichnet, dass** die Leiterplattenstruktur (17) eine Kavität (41) aufweist, in welcher der Sensor (30) als Drucksensor ausgebildet angeordnet ist

11. Modulare elektrische Zigarette (1) gemäss einem der Ansprüche 1 bis 10, **dadurch gekennzeichnet, dass** der mit der elektrischen Zigarette (1) ausgebildete Passsitz des Steuerelementkörpers (5) als eine Spielpassung ausgebildet ist, wobei der Steuerelementkörper (5) gerade noch leicht verschiebbar angeordnet ist.

12. Modulare elektrische Zigarette (1) gemäss einem der Ansprüche 1 bis 10, **dadurch gekennzeichnet, dass** der mit der elektrischen Zigarette (1) ausgebildete Passsitz des Steuerelementkörpers (5) als eine Übergangspassung ausgebildet ist, wobei der Steuerelementkörper (5) mit geringem Druck verschiebbar angeordnet ist.

## Claims

1. Modular electric cigarette (1) which has a cartridge unit (2) and a control unit (3) detachably arranged thereon along a central Z-axis from bottom to top, the electric cigarette (1) terminating at the bottom with a mouthpiece end (25) and at the top with a charging tip (4), wherein the electric cigarette (1) has a circular cross-sectional area (40) over its entire length and comprises a first and/or a second and/or a third control element body (5) with a body diameter (6a, 6b, 6c) perpendicular to the central Z-axis, wherein this respective body diameter (6a, 6b, 6c) is selected such that the control element body (5) forms a tight fit with the electric cigarette (1), **characterized in that** the second control element body (5) is designed as a charging tip control (5a), which is arranged on the charging tip (4) with a snug fit and closes off the electric cigarette (1) at the top, **in that** the third control element body (5) is designed as a cartridge control (5c), which terminates the cartridge unit (2) upwardly with the fitting seat, and **in that** the control unit (3) comprises a battery sleeve (9) with a non-conductive outer tube (11) and an electrically conductive inner tube (12a), which can form an electrical active connection between the charging tip control (5a), the control unit (5b) and the cartridge control (5c).

2. Modular electric cigarette (1) according to claim 1, **characterized in that** the circular cross-sectional area (40) of the electric cigarette (1) is the same size over its entire longitudinal extent.

3. Modular electric cigarette (1) according to one of claims 1 or 2, **characterized in that** the first control element body (5) is designed as a control unit (5b), which is arranged between the cartridge unit (2) and the control unit (3) with the fit and closes off the control unit (3) towards this cartridge unit (2).

4. Modular electric cigarette (1) according to one of claims 1 to 3, **characterized in that** the charging tip control (5a) and/or the control unit (5b) and/or the cartridge control (5c) is designed as a printed circuit board structure (17).

5. Modular electric cigarette (1) according to claim 4, **characterized in that** the printed circuit board structure (17) comprises at least one printed circuit board (33) insulated by means of an insulating filling (32), this at least one printed circuit board (33) being oriented transversely to the Z-axis.

6. Modular electric cigarette (1) according to claim 5, **characterized in that** the at least one printed circuit board (33) has at least one sensor (30) and/or at least one microcontroller (29) and/or at least one electronic component (31), which are electrically connected to the number of electrical contacts (14, 14a - 14i) on this at least one printed circuit board (33) and/or by means of a conductor track and/or by means of a through-plating (27), or to a surface contact (15).

7. Modular electric cigarette (1) according to claim 6, **characterized in that** the at least one sensor (30) and/or the at least one microcontroller (29) and/or the at least one electronic component (31) with the at least one printed circuit board (33) are designed as integrated electronic components embedded in the printed circuit board structure (17).

8. Modular electric cigarette (1) according to any one of claims 4 to 7, **characterized in that** the printed circuit board structure (17) comprises an authentication device (26).

9. Modular electric cigarette (1) according to any one of claims 4 to 7, **characterized in that** the circuit board structure (17) comprises a switching element (28).

10. Modular electric cigarette (1) according to one of claims 6 or 7, **characterized in that** the printed circuit board structure (17) comprises a cavity (41) in which the sensor (30) is arranged as a pressure sensor.

11. Modular electric cigarette (1) according to one of claims 1 to 10, **characterized in that** the fit of the control element body (5) formed with the electric cigarette (1) is designed as a clearance fit, the control element body (5) being arranged so as to be just slightly displaceable.

12. Modular electric cigarette (1) according to one of claims 1 to 10, **characterized in that** the fit of the control element body (5) formed with the electric cigarette (1) is designed as a transition fit, the control element body (5) being arranged so as to be displaceable with slight pressure.

## Revendications

1. Cigarette électrique modulaire (1), qui présente le long d'un axe Z central de bas en haut une unité de cartouche (2) et une unité de contrôle (3) disposée de manière amovible sur celle-ci, la cigarette électrique (1) se terminant en bas par une extrémité d'embout (25) et en haut par une pointe de charge (4), la cigarette électrique (1) présentant sur toute sa longueur une surface de section transversale circulaire (40) et comprenant un premier et/ou un deuxième et/ou un troisième corps d'élément de commande (5) avec un diamètre de corps (6a, 6b, 6c) perpendiculaire à l'axe central Z, ce diamètre de corps respectif (6a, 6b, 6c) étant choisi de telle sorte que le corps d'élément de commande (5) forme un ajustement serré avec la cigarette électrique (1), **caractérisé en ce que** le deuxième corps d'élément de commande (5) est réalisé sous la forme d'une commande de pointe de charge (5a) qui est disposée sur la pointe de charge (4) avec un ajustement et qui ferme la cigarette électrique (1) vers le haut, **en ce que** le troisième corps d'élément de commande (5) est réalisé sous la forme d'une commande de cartouche (5c), qui ferme l'unité de cartouche (2) vers le haut avec le siège d'ajustement, et **en ce que** l'unité de contrôle (3) comprend un manchon de batterie (9) avec un tube extérieur non conducteur (11) et un tube intérieur électriquement conducteur (12a) qui peut former une connexion électrique fonctionnelle entre le contrôleur d'embout de charge (5a), l'unité de contrôle (5b) et le contrôleur de cartouche (5c).

2. Cigarette électrique modulaire (1) selon la revendication 1, **caractérisée en ce que** la surface de section circulaire (40) de la cigarette électrique (1) est la même sur toute sa longueur.

3. Cigarette électrique modulaire (1) selon l'une des revendications 1 ou 2, **caractérisée en ce que** le premier corps d'élément de commande (5) est réalisé sous forme d'une unité de commande (5b) qui est disposée entre l'unité de cartouche (2) et l'unité de contrôle (3) avec le siège d'ajustage et qui ferme l'unité de contrôle (3) vers cette unité de cartouche (2).

4. Cigarette électrique modulaire (1) selon l'une des revendications 1 à 3, **caractérisée en ce que** la commande de l'embout de chargement (5a) et/ou l'unité de commande (5b) et/ou la commande de la cartouche (5c) est réalisée sous la forme d'une structure de carte de circuit imprimé (17).

5. Cigarette électrique modulaire (1) selon la revendication 4, **caractérisée en ce que** la structure de carte de circuit imprimé (17) comprend au moins une carte de circuit imprimé (33) isolée au moyen d'un remplissage isolant (32), cette au moins une carte de circuit imprimé (33) étant orientée transversalement à l'axe Z.

6. Cigarette électrique modulaire (1) selon la revendication 5, **caractérisée en ce que** l'au moins une carte de circuit imprimé (33) présente au moins un capteur (30) et/ou au moins un microcontrôleur (29) et/ou au moins un composant électronique (31) qui sont en liaison électrique active sur cette au moins une carte de circuit imprimé (33) et/ou au moyen d'une piste conductrice et/ou au moyen d'un contact traversant (27) avec le nombre de contacts électriques (14, 14a - 14i), ou avec un contact de surface d'enveloppe (15).

7. Cigarette électrique modulaire (1) selon la revendication 6, **caractérisée en ce que** l'au moins un capteur (30) et/ou l'au moins un microcontrôleur (29) et/ou l'au moins un composant électronique (31) avec l'au moins une carte de circuit imprimé (33) sont réalisés sous forme de composants électroniques intégrés, noyés dans la structure de carte de circuit imprimé (17).

8. Cigarette électrique modulaire (1) selon l'une des revendications 4 à 7, **caractérisée en ce que** la structure de carte de circuit imprimé (17) comprend un dispositif d'authentification (26).

9. Cigarette électrique modulaire (1) selon l'une des revendications 4 à 7, **caractérisée en ce que** la structure de circuit imprimé (17) comprend un élément de commutation (28).

10. Cigarette électrique modulaire (1) selon l'une des revendications 6 ou 7, **caractérisée en ce que** la structure de carte de circuit imprimé (17) présente une cavité (41) dans laquelle est disposé le capteur (30) conçu comme un capteur de pression.

11. Cigarette électrique modulaire (1) selon l'une des revendications 1 à 10, **caractérisée en ce que** l'ajustement du corps de l'élément de commande (5) réalisé avec la cigarette électrique (1) est réalisé sous la forme d'un ajustement avec jeu, le corps de l'élément de commande (5) étant disposé de manière à pouvoir encore tout juste légèrement coulisser.

12. Cigarette électrique modulaire (1) selon l'une des revendications 1 à 10, **caractérisée en ce que** le siège d'ajustement du corps d'élément de commande (5) réalisé avec la cigarette électrique (1) est réalisé sous la forme d'un ajustement de transition, le corps d'élément de commande (5) étant disposé de manière à pouvoir être déplacé avec une faible pression.
